# EUROPÄISCHE PATENTSCHRIFT

(11) **EP 3 537 166 B1**
(45) Veröffentlichungstag und Bekanntmachung des Hinweises auf die Patenterteilung: **17.11.2021**
(21) Anmeldenummer: 18160242.6
(22) Anmeldetag: 06.03.2018
(51) Int. Cl.: G01R 33/483, G01R 33/56, G01R 33/561

(54) **VERFAHREN ZUR AUFNAHME VON MAGNETRESONANZDATEN MIT EINER MAGNETRESONANZEINRICHTUNG, MAGNETRESONANZEINRICHTUNG, COMPUTERPROGRAMM UND ELEKTRONISCH LESBARER DATENTRÄGER**
METHOD FOR RECORDING MAGNETIC RESONANCE DATA WITH A MAGNETIC RESONANCE DEVICE, MAGNETIC RESONANCE DEVICE, COMPUTER PROGRAM AND ELECTRONICALLY READABLE DATA CARRIER
PROCÉDÉ D'ENREGISTREMENT DE DONNÉES DE RÉSONANCE MAGNÉTIQUE AU MOYEN D'UN DISPOSITIF DE RÉSONANCE MAGNÉTIQUE, DISPOSITIF DE RÉSONANCE MAGNÉTIQUE, PROGRAMME INFORMATIQUE ET SUPPORT D'INFORMATIONS LISIBLE ÉLECTRONIQUEMENT

(43) Veröffentlichungstag der Anmeldung: 11.09.2019
(73) Patentinhaber: Siemens Healthcare GmbH, 91052 Erlangen (DE)
(72) Erfinder: Zeller, Mario, 91054 Erlangen (DE)

(56) Entgegenhaltungen:
- US-A1- 2016 299 205
- US-A1- 2017 108 567
- US-A1- 2017 315 202
- BREUTIGAM N.-J. ET AL.: "Simultaneous Multi-contrast Imaging with Readout-Segmented EPI", PROCEEDINGS OF THE INTERNATIONAL SOCIETY FOR MAGNETIC RESONANCE IN MEDICINE, 25TH ANNUAL MEETING & EXHIBITION, Nr. 520, 7. April 2017 (2017-04-07), XP040688088, Honolulu, HI, USA
- KIM S.-E. ET AL.: "Time Efficient Triple Contrast Acquisition in Double Inversion Fast Spin Echo", PROCEEDINGS OF THE INTERNATIONAL SOCIETY FOR MAGNETIC RESONANCE IN MEDICINE, 12TH SCIENTIFIC MEETING & EXHIBITION, 15. Mai 2004 (2004-05-15), Seite 698, XP040590639, Kyoto, Japan

## Beschreibung

Die Erfindung betrifft ein Verfahren zur Aufnahme eines Magnetresonanzdatensatzes in einem mehrere Schichten umfassenden Aufnahmebereich eines Untersuchungsobjekts mit einer Magnetresonanzeinrichtung, wobei eine Bildgebungstechnik verwendete wird, die bei der Rekonstruktion von Magnetresonanzbildern Referenzdaten nutzt, wobei für alle Schichten wenigstens zwei Teildatensätze mit jeweils unterschiedlichen Kontrasten aufgenommen werden, indem ein erster Teildatensatz ohne einen und ein zweiter Teildatensatz mit einem Präparationspuls, insbesondere Inversionspuls, aufgenommen wird. Daneben betrifft die Erfindung eine Magnetresonanzeinrichtung, ein Computerprogramm und einen elektronisch lesbaren Datenträger.

Die Magnetresonanzbildgebung hat sich inzwischen für die Aufnahme von Patienten in klinischen Umgebungen etabliert. Dabei wurden eine Vielzahl unterschiedlicher Bildgebungstechniken vorgeschlagen, mit denen unterschiedliche, diagnostisch nützliche Informationen aus einem Aufnahmebereich eines Untersuchungsobjekts, insbesondere eines Patienten, gewonnen werden können. Neben den üblichen, unterschiedlichen Gewichtungen (T1-Kontrast, T2-Kontrast, T2*-Kontrast, Protonendichte-Kontrast) wurde eine Vielzahl weiterer Möglichkeiten vorgeschlagen, verschiedene Kontraste in Magnetresonanzdaten zu erhalten. Insbesondere werden hierbei auf eine jeweilige Schicht wirkende Präparationspulse, beispielsweise Inversionspulse, eingesetzt, wobei sich der eigentliche Echozug mit dem Anregungspuls und den entsprechenden Auslesezeiträumen nach einer bestimmten Wartezeit, im Falle eines Inversionspulses der Inversionszeit, anschließen kann. Die Wartezeit kann dabei eine signifikante Länge aufweisen, beispielsweise eine Sekunde oder mehr.

Ein Beispiel für eine um einen Präparationspuls erweiterte Magnetresonanzsequenz, die einen bestimmten gewünschten Kontrast liefert, ist die T2-gewichtete FLAIR-Sequenz (FLAIR - Fluid-Attenuated Inversion Recovery). Dabei sollen Magnetresonanzsignale von Flüssigkeiten unterdrückt werden, insbesondere bezüglich der zerebrospinalen Fluide (CSF). Eine typische Inversionszeit (TI) für diesen Kontrast ist 2,5 Sekunden.

Nachdem derartige Wartezeiten im Allgemeinen die Dauer der Aufnahme deutlich verlängern, wurden verschiedene Möglichkeiten zur Beschleunigung der Gesamtaufnahme, mithin zur Erniedrigung der Gesamtaufnahmezeit, vorgeschlagen. Beispielsweise ist es bekannt, Turbo-Spinecho-Sequenzen (TSE-Sequenzen) einzusetzen, die es durch wiederholte Refokussierungspulse erlauben, mehrere Auslesemodule nach einen einzigen Anregungspuls (und somit auch einen einzigen Präparationspuls) zu schalten.

Eine weitere Möglichkeit zur Beschleunigung der Gesamtaufnahme sind Mehrschichtbildgebungstechniken, welche auch als SMS-Techniken (Simultaneous Multi-Slice) bezeichnet werden. Der Einsatz solcher Mehrschichtbildgebungstechniken zur Beschleunigung wurde insbesondere bei der Aufnahme von Magnetresonanzdatensätzen vorgeschlagen, welche Teildatensätze unterschiedlichen Kontrasts aufweisen sollen, beispielsweise T2 und T2-FLAIR. Dabei schlägt beispielsweise US 2017/0315202 A1 vor, bei der gleichzeitigen Aufnahme zweier Schichten eine Schicht aufgrund der Gabe eines Präparationspulses mit einem der Kontraste, die andere Schicht, insbesondere ohne einen Präparationspuls, für den anderen Kontrast aufzunehmen, woraufhin in einem späteren Aufnahmeschritt die beiden Schichten erneut gleichzeitig mit vertauschten Kontrasten aufgenommen werden, so dass dann der Präparationspuls auf die andere Schicht wirkt. Somit wird bei der Aufnahme von Magnetresonanzdatensätzen mit Teildatensätzen unterschiedlicher Kontraste bereits eine deutliche Beschleunigung erreicht, da zwei Repetitionen ausreichend sind, um Magnetresonanzdaten zu zwei unterschiedlichen aufzunehmenden Schichten in beiden gewünschten Kontrasten zu erhalten. Ein vergleichbares Vorgehen wurde für eine Kombination eines Diffusions-Kontrastes und eines T2*-Kontrastes mittels der RESOLVE-Sequenz in einem Artikel von Nora-Josefin Breutigam et al., "Simultaneous Multi-Contrast Imaging with Readout-Segmented EPI", ISMRM 2017, vorgeschlagen.

Um bei der SMS-Bildgebung zwei oder mehr gleichzeitig aufgenommene Schichten, konkret deren überlagerte ("collapsed") Magnetresonanzdaten zu trennen, wird üblicherweise als Trennungsalgorithmus der sogenannte Schicht-GRAPPA-Algorithmus eingesetzt, welcher beispielsweise im Artikel von Kawin Setsompop et al., "Blipped-Controlled Aliasing in Parallel Imaging (blipped-CAIPI) for simultaneous multi-slice EPI with reduced g-factor penalty", Magn Reson Med. 67 (2012), Seiten 1210 - 1224, beschrieben. Um bestimmte Schichten voneinander trennen zu können, muss der Trennungsalgorithmus für diese Schichten parametrisiert werden, das bedeutet, es müssen Parameter, im konkreten Beispiel eines GRAPPA-Kerns, bestimmt werden. Grundlage für diese Bestimmung sind Referenzdaten, die von den einzelnen, später gemeinsam aufgenommenen Schichten ohne Überlagerung aufgenommen wurden.

Die nachveröffentlichte US-Patentanmeldung US 15/262,233 betrifft die Problematik, dass die üblicherweise mit einer Gradientenechosequenz (GRE-Sequenz) aufgenommenen Referenzdaten nicht zu den später mit einer TSE-Sequenz aufgenommenen Magnetresonanzdaten der SMS-Aufnahme passen. Zur Lösung wird dort vorgeschlagen, einen TSE-basierten Referenzscan zur Aufnahme der Referenzdaten zu verwenden, der insbesondere eine RARE-Sequenz (Rapid Acquisition with Relaxation Enhancement) oder eine HASTE-Sequenz (Half-Fourier Acquisition Single-shot Turbo Spin Echo) sein kann. Mithin werden dort die Referenzdaten für den gesamten, den Aufnahmebereich abdeckenden Schichtstapel in einem Referenzscan vor oder nach der SMS-Magnetresonanzdatenaufnahme aufgenommen. Schichten, die später gemeinsam aufgenommen werden, werden künstlich überlagert und entsprechende Schicht-GRAPPA-Kerne werden generiert, um die Trennung der überlagerten Magnetresonanzdaten der wenigstens zwei Schichten zu ermöglichen.

Dabei ergeben sich jedoch Probleme bei dem simultanen Mehrfachkontrast-Ansatz, wie er beispielsweise in US 2017/0315202 A1 beschrieben ist. Betreffen die Referenzdaten nur einen der Kontraste, während die Magnetresonanzdaten zwei unterschiedliche Kontraste in jeweiligen Teildatensätzen abbilden, passen die Referenzdaten zumindest zu dem Teildatensatz mit geändertem Kontrast nicht vollständig. Das kann zu Crosstalk-Effekten zwischen den Schichten führen, wenn eine falsche Schichttrennung vorgenommen wird, was wiederum die Bildqualität negativ beeinflusst.

In dem zuvor genannten Konferenzbeitrag von Nora-Josefin Breutigam et al. wird das Problem gelöst, indem zwei getrennte Referenzscans durchgeführt werden, um Referenzdaten für beide Kontraste zu erhalten, so dass auch entsprechend zwei Sätze von Parametern für den Trennungsalgorithmus bestimmt werden. In der dortigen Konstellation, in der es hauptsächlich um den DWI-Kontrast und einen herkömmlichen T2*-Kontrast geht, können beide Referenzdatensätze in relativ kurzer Zeit aufgenommen werden, da Wartezeiten bei DWI (Diffusion-Weighted Imaging) geringer sind. Probleme treten jedoch bei der Verwendung von Kontrasten mit äußerst langen Wartezeiten nach dem Präparationspuls auf, beispielsweise bei der Kombination von T2 und T2-FLAIR. Dann würde die Aufnahme jeweiliger Referenzdatensätze für beide Kontraste eine sehr lange Zeit aufgrund der langen Inversionszeit TI und der Repetitionszeit TR des FLAIR-Scans in Anspruch nehmen.

US 2016/299205 A1 betrifft eine Magnetresonanzeinrichtung und ein Verfahren zum Erhalt eines Magnetresonanzbildes davon. In einem Ausführungsbeispiel können eine Vielzahl von Hochfrequenzpulsen ausgegeben werden, um aus unterschiedlichen Schichten eines Objekts Magnetresonanzsignale aufzunehmen, die unterschiedlichen Kontrasten entsprechen, konkret ein FLAIR-Bild und einen anderen Kontrast. Während einer Verzögerungszeit für die FLAIR-Aufnahme können Magnetresonanzsignale aus einer anderen Schicht aufgenommen werden.

Der Erfindung liegt daher die Aufgabe zugrunde, eine Möglichkeit zur vollständigen, beschleunigten Aufnahme von Referenzdaten bei der Bildgebung mit mehreren Kontrasten anzugeben.

Zur Lösung dieser Aufgabe sind erfindungsgemäß ein Verfahren, eine Magnetresonanzeinrichtung, ein Computerprogramm und ein elektronisch lesbarer Datenträger gemäß den unabhängigen Ansprüchen vorgesehen. Vorteilhafte Ausgestaltungen ergeben sich aus den Unteransprüchen.

In einem erfindungsgemäßen Verfahren der eingangs genannten Art werden zur Aufnahme der Referenzdaten für wenigstens eine erste Schicht für den ersten Teildatensatz die Referenzdaten in einer Wartezeit nach dem Präparationspuls für wenigstens eine andere, zweite Schicht, von der Referenzdaten bezüglich des zweiten Teildatensatzes aufgenommen werden sollen, aufgenommen.

Es wird eine zeiteffiziente Methode vorgeschlagen, die die Aufnahme aller notwendigen Referenzdaten der unterschiedlichen Kontraste erlaubt. Mit besonderem Vorteil wird dabei zur Aufnahme der Referenzdaten eine Einzelschuss-TSE-Sequenz verwendet, vorzugsweise eine HASTE-Sequenz (Half-Fourier Acquisition Single-Shot Turbo Spin Echo). Die solchen Einzelschuss-TSE-Sequenzen zugeordneten Echozüge benötigen eine recht kurze Zeit und können mithin in den Präparationspulsen nachfolgenden Wartezeiten, beispielsweise Inversionszeiten, ausgespielt werden, um mithin, während auf die Aufnahme von Referenzdaten des zweiten Teildatensatzes in zweiten Schichten gewartet wird, Referenzdaten des ersten Teildatensatzes in jeweils anderen ersten Schichten aufzunehmen. Auf diese Weise wird die Effizienz der Aufnahme der Referenzdaten deutlich erhöht. Die Aufnahmezeit für die Referenzdatensätze wird deutlich reduziert, wobei aufgrund des Vorliegens von Referenzdatensätzen für beide Teildatensätze, mithin beide Kontraste, eine hochqualitative Trennung von Magnetresonanzdaten der überlagerten Schichten bei der Multikontrast-SMS-Bildgebung oder sonstige hohe Qualität bei anderen, Referenzdaten benötigten Mehrkontrast-Aufnahmen gegeben ist.

Dabei lässt sich die vorliegende Erfindung auf eine Vielzahl von unterschiedlichen Kombinationen von Kontrasten anzuwenden, wobei bevorzugt eine Kombination von einem herkömmlichen Kontrast (mithin ohne Gabe eines Präparationspulses) und einem Kontrast mit langer Wartezeit nach dem Präparationspuls betrachtet wird. Beispielsweise können als Kontraste eine T2-Gewichtung und eine T2-FLAIR-Gewichtung verwendet werden, wobei andere Beispiele für Kontraste unter Verwendung eines Präparationspulses STIR (Short Tau Inversion Recovery) und Diffusionsgewichtungen umfassen.

In einer besonders vorteilhaften Weiterbildung der vorliegenden Erfindung kann vorgesehen sein, dass zur Aufnahme der Referenzdaten Präparationspulse für mehrere unterschiedliche zweite Schichten sukzessive ausgegeben werden, wobei in Zeiträumen zwischen der Ausgabe von zwei Präparationspulsen und nach der Ausgabe des letzten Präparationspulses jeweils Referenzdaten für von den zweiten Schichten unterschiedliche erste Schichten aufgenommen werden. Mithin ist eine geschachtelte Aufnahme denkbar, wobei ein Echozug zur Aufnahme von Referenzdaten einer ersten Schicht zwischen zwei Präparationspulsen beziehungsweise nach dem letzten Präparationspuls zum Liegen kommt, woran sich dann die entsprechenden Echozüge zur Aufnahme von Referenzdaten für die zweiten Schichten, auf die die Präparationspulse gewirkt haben, anschließen. Nachdem der zeitliche Abstand zwischen den einzelnen Präparationspulsen für jeweilige einzelne zweite Schichten abhängig von der Dauer des Echozuges nach der Wartezeit TI für die jeweiligen zweiten Schichten ist, ist es möglich, einen zusätzlichen Auslese-Echozug für eine erste Schicht zwischen zwei Präparationspulsen vorzusehen, ohne die Präparationszeit signifikant zu erhöhen. Auf diese Weise kann die Sequenz-Effizienz weiter deutlich erhöht werden.

Dabei sei an dieser Stelle noch angemerkt, dass es selbstverständlich zweckmäßig ist, nach einer derartigen Repetition eine weitere Repetition vorzusehen, in der die ersten Schichten und die zweiten Schichten gerade vertauscht sind, so dass am Ende für alle ersten und zweiten Schichten einer solchen Repetition Referenzdaten vorliegen.

In einem Beispiel, in dem die Wartezeit TI 2,5 Sekunden beträgt und ein Präparationspuls, beispielsweise ein Inversionspuls, 10 ms dauert, können bei einer Auslese-Echozuglänge von etwa 100 ms Referenzdaten für 22 Schichten für jeden Kontrast innerhalb einer Repetitionszeit TR, die dann etwa 5 Sekunden beträgt, aufgenommen werden. In einer zweiten Repetitionszeit TR, können die Schichten, die von jedem Kontrast betroffen werden sollen, ausgetauscht werden, so dass dann für 44 Schichten Referenzdaten für beide Kontraste vorliegen. Für mehr Schichten, beispielsweise mehr als 44 Schichten im gezeigten Beispiel, werden weitere Repetitionen benötigt.

Die Menge an Daten, die in einer einzigen Repetitionszeit TR aufgenommen werden kann, hängt von der Wartezeit TI zwischen den Präparationspuls und dem Auslese-Echozug ab, wobei, wie dargelegt, die Inversionszeit bei FLAIR beispielsweise etwa 2,5 Sekunden betragen kann. Das Verfahren kann jedoch im Prinzip auf alle Kombinationen von herkömmlichen gewichteten Kontrasten ohne Präparationspuls und durch schichtspezifische Präparationspulse vorbereitete Kontraste angewandt werden, so lange die Dauer des Echozuges kürzer ist als die Wartezeit. Beispielsweise treten bei diffusionsgewichteten Kontrasten oder STIR deutlich kürzere Inversionszeiten TI von etwa 220 ms auf.

Gemäß der vorliegenden Erfindung wird als Bildgebungstechnik eine Mehrschichtbildgebungstechnik verwendet, mithin eine SMS-Bildgebungstechnik, in der in einem Aufnahmeabschnitt gleichzeitig Magnetresonanzdaten aus wenigstens zwei Schichten aufgenommen werden und mittels eines die Referenzdaten der einzelnen Schichten nutzenden Trennungsalgorithmus den einzelnen Schichten zugeordnet werden. Dabei ist es von besonderem Vorteil, wenn die in US 2017/0315202 A1 beschriebene Vorgehensweise eingesetzt wird, insbesondere also in jedem gemeinsamen Aufnahmeschritt für zwei Schichten jeweils für eine der Schichten mittels eines auf diese Schicht wirkenden Präparationspulses Magnetresonanzdaten des zweiten Teildatensatzes und für die andere Schicht Daten des ersten Teildatensatzes aufgenommen werden. Zweckmäßigerweise erfolgt in einer weiteren Repetition eine erneute Durchführung mit vertauschten Schichten. Dabei werden insbesondere zur Ermittlung der Parameter des Trennungsalgorithmus jeweils die den gemeinsam aufgenommenen Schichten entsprechenden Kombinationen der Referenzdaten für die unterschiedlichen Kontraste herangezogen, so dass beispielsweise für die eine Schicht, auf die der Präparationspuls wirkt, Referenzdaten dieser Schicht bezüglich des zweiten Teildatensatzes herangezogen werden, während für die andere Schicht Referenzdaten des ersten Teildatensatzes verwendet werden, um insbesondere die entsprechenden Schicht-GRAPPA-Kerne zu ermitteln. Dabei werden die entsprechenden Referenzdaten künstlich unter Berücksichtigung entsprechend auftretender Schichtverschiebungen überlagert und die Parameter des Trennungsalgorithmus, wie im Stand der Technik bekannt, ermittelt. Wird in einer weiteren Repetition die umgekehrte Kombination von Schichten herangezogen, muss entsprechend auch die umgekehrte Kombination von Referenzdaten verwendet werden, um die korrekten Schicht-GRAPPA-Kerne zu erhalten.

Es sei angemerkt, dass dieses Verfahren selbstverständlich auch für SMS-Beschleunigungsfaktoren größer als zwei eingesetzt werden können, indem entsprechend Schichten mit unterschiedlichen Kontrasten der Referenzdaten kombiniert werden. Es sei ferner im Allgemeinen darauf hingewiesen, dass die Positionen der Schichten im Aufnahmebereich selbstverständlich, wie grundsätzlich bekannt, so gewählt werden, dass Schicht-Crosstalk zwischen unterschiedlichen Kontrasten minimiert wird.

Es sei ferner darauf hingewiesen, dass das Verfahren nicht nur für die Mehrschicht SMS-Bildgebung äußerst nützlich ist, sondern auch zur zeiteffizienten Referenzdatenaufnahme für Nicht-SMS-Mehrkontrast-Bildgebungstechniken angewendet werden kann. Ein Beispiel für solche Mehrkontrast-Techniken ohne Mehrschichtbildgebung sind MP2RAGE-Varianten.

Neben dem Verfahren betrifft die Erfindung auch eine Magnetresonanzeinrichtung, aufweisend eine zur Durchführung des erfindungsgemäßen Verfahrens ausgebildete Steuereinrichtung. Die Steuereinrichtung kann hierbei insbesondere wenigstens einen Prozessor und wenigstens ein Speichermittel aufweisen. Sämtliche Ausführungen bezüglich des erfindungsgemäßen Verfahrens lassen sich analog auf die erfindungsgemäße Magnetresonanzeinrichtung übertragen, mit welcher mithin auch die genannten Vorteile erzielt werden können. Insbesondere kann die Steuereinrichtung mithin neben einer Sequenzeinheit zur Aufnahme von Magnetresonanzdaten/Referenzdaten, wie grundsätzlich bekannt, eine Timing-Einheit für Ermittlungen der Zeitabläufe bei der Aufnahme der Referenzdaten aufweisen, denen entsprechend die Sequenzeinheit die Aufnahme der Referenzdaten steuert.

Ein erfindungsgemäßes Computerprogramm ist beispielsweise direkt in einen Speicher einer Steuereinrichtung einer Magnetresonanzeinrichtung ladbar und weist Programmmittel auf, um die Schritte eines erfindungsgemäßen Verfahrens auszuführen, wenn das Computerprogramm in der Steuereinrichtung der Magnetresonanzeinrichtung ausgeführt wird. Das Computerprogramm kann auf einem erfindungsgemäßen elektronisch lesbaren Datenträger gespeichert sein, welcher mithin darauf gespeicherte elektronisch lesbare Steuerinformationen umfasst, welche zumindest ein erfindungsgemäßes Computerprogramm umfassen und derart ausgestaltet sind, dass sie bei Verwendung des Datenträgers in einer Steuereinrichtung einer Magnetresonanzeinrichtung ein erfindungsgemäßes Verfahren durchführen. Bei dem Datenträger kann es sich insbesondere um einen nicht transienten Datenträger, beispielsweise eine CD-ROM, handeln.

Weitere Vorteile und Einzelheiten der vorliegenden Erfindung ergeben sich aus den im Folgenden beschriebenen Ausführungsbeispielen sowie anhand der Zeichnung. Dabei zeigen:
- Fig. 1: einen zeitlichen Ablauf der Aufnahme von Referenzdaten gemäß der vorliegenden Erfindung,
- Fig. 2: einen beispielhaft verwendbaren Echozug,
- Fig. 3: eine Skizze zur Ermittlung von Parametern eines Trennungsalgorithmus und deren Anwendung bei der Rekonstruktion von Magnetresonanzbildern, und
- Fig. 4: eine erfindungsgemäße Magnetresonanzeinrichtung.

Im Folgenden soll nun ein Ausführungsbeispiel der vorliegenden Erfindung dargestellt werden, bei dem mittels einer Mehrschichtbildgebungstechnik (SMS-Bildgebung) als Magnetresonanzdaten zwei Teilbildsätze eines in Schichten unterteilten Aufnahmebereichs eines Patienten aufgenommen werden sollen, beispielsweise eines Aufnahmebereichs im Gehirn eines Patienten, wobei ein Teilbilddatensatz mit herkömmlicher T2-Gewichtung, also ohne Präparationspuls, und ein weiterer Teilbilddatensatz mit T2-FLAIR-Gewichtung, mithin einem anderen Kontrast, der einen Inversionspuls als Präparationspuls benötigt, aufgenommen werden sollen.

Dabei ist vorgesehen, bei der SMS-Bildgebung immer zwei Schichten gleichzeitig aufzunehmen, wobei auf eine der Schichten ein Präparationspuls wirkt, so dass Magnetresonanzdaten des zweiten Teildatensatzes entstehen, während für die andere Schicht, auf die der Präparationspuls nicht wirkt und für die kein Präparationspuls vorgesehen ist, Magnetresonanzdaten des ersten Teildatensatzes aufgenommen werden. In einer weiteren Repetition werden Schichten vertauscht, so dass der Präparationspuls dann auf die andere Schicht wirkt und von dieser Magnetresonanzdaten des zweiten Teildatensatzes aufgenommen werden, wie beispielsweise in US 2017/00315202 A1 beschrieben. Um mittels eines Trennungsalgorithmus, hier eines Schicht-GRAPPA-Algorithmus, verlässlich und mit hoher Qualität die Magnetresonanzdaten der gleichzeitig aufgenommenen Schichten trennen zu können, sind Referenzdaten ohne Mehrschichtbildgebung für jede der Schichten im passenden Kontrast erforderlich.

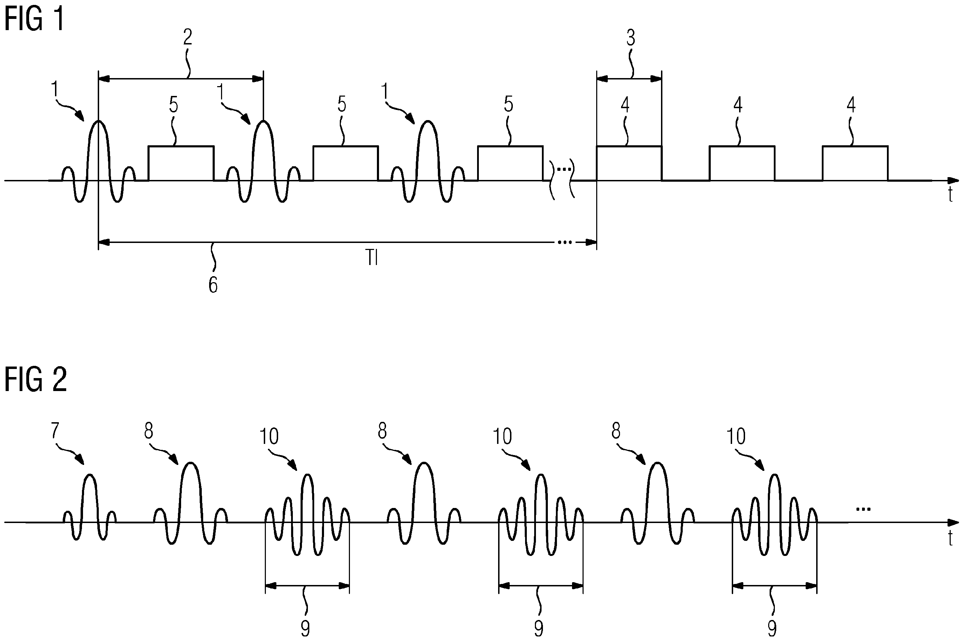

Fig. 1 zeigt einen Zeitablauf einer Repetition, in dem Referenzdaten für mehrere der Schichten des Aufnahmebereichs aufgenommen werden können.

Dabei werden ersichtlich Präparationspulse 1 für eine Anzahl zweiter Schichten in einem zeitlichen Abstand 2 ausgegeben, der sich im Wesentlichen nach der Dauer 3 der zugeordneten Echozüge 4, vorliegend unter Nutzung der HASTE-Sequenz, richten. Dieser zeitliche Abstand 2 wird nun genutzt, um zwischen den Präparationspulsen 1 und nach dem letzten Präparationspuls 1 Echozüge 5, ebenfalls unter Nutzung der HASTE-Sequenz, zu platzieren, um Referenzdaten für den ersten Teilbilddatensatz für von den zweiten Schichten unterschiedliche erste Schichten aufzunehmen, wobei sich die Zahl von insgesamt aufnehmbaren Referenzdaten, mithin die Anzahl der ersten und zweiten Schichten zusammen, anhand der Wartezeit 6, hier Inversionszeit TI, ergibt. Beträgt die Inversionszeit, wie für T2-FLAIR üblich, beispielsweise 2,5 Sekunden, dauert die Ausgabe eines Präparationspulses 1 10 ms und beträgt die Länge der Auslese-Echozüge 4, 5 100 ms, können in jeder Repetition von ca. 5 Sekunden 22 Schichten jedes Kontrastes, insgesamt also 44 Schichten, aufgenommen werden. Um die Referenzdaten für die jeweils anderen Kontraste, also die jeweils anderen Teildatensätze, für die ersten und die zweiten Schichten zu erhalten, werden in einer weiteren Repetition gemäß Fig. 1 die ersten und die zweiten Schichten entsprechend vertauscht.

Fig. 2 zeigt den Ablauf eines Echozuges 4, 5, bei dem es sich vorliegend um einen Einzelschuss-TSE-Echozug, konkret HASTE-Echozug, handelt. Dabei wird zunächst ein Anregungspuls 7 ausgegeben, dem eine regelmäßige Abfolge von Refokussierungspulsen 8 und Auslesezeiträume 9, angedeutet durch das Magnetresonanzsignal 10, folgen. Durch die Nutzung der Refokussierungspulse 8 kann eine größere Zahl von k-Raumlinien abgetastet werden.

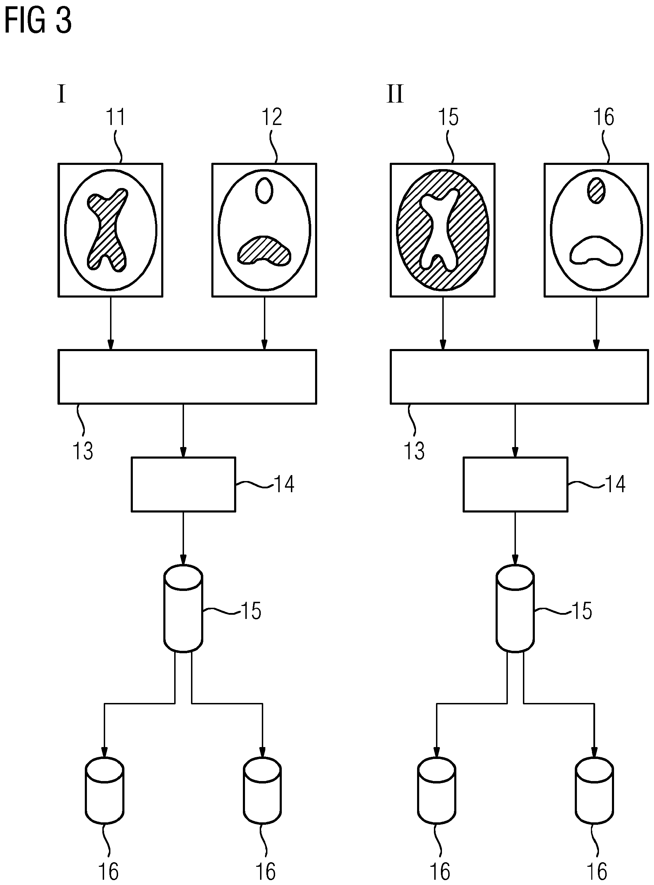

Fig. 3 erläutert schließlich, wie Parameter für den Trennungsalgorithmus ermittelt und bei der Rekonstruktion von Magnetresonanzbildern genutzt werden. Wie bereits erwähnt, wird bei der Aufnahme der Magnetresonanzdaten unter Nutzung der SMS-Bildgebung von zwei gleichzeitig aufzunehmenden Schichten eine mit dem T2-Kontrast, die andere mit dem T2-FLAIR-Kontrast aufgenommen, in einer zweiten Repetition umgekehrt die andere Schicht mit dem T2-Kontrast und die eine Schicht mit dem T2-FLAIR-Kontrast. Zur Ermittlung der Parameter des Trennungsalgorithmus für die erste Repetition, in Fig. 3 mit I bezeichnet, werden mithin für die eine Schicht Referenzdaten 12 des ersten Teildatensatzes und für andere Schicht Referenzdaten 11 des zweiten Teildatensatzes herangezogen, um einen kombinierten überlagerten Datensatz in einem Schritt 13 zu erzeugen, aus dem ein erster Satz von Parametern des Trennungsalgorithmus, hier des Schicht-GRAPPA-Kerns, in einem Schritt 14 hergeleitet werden. Entsprechende Schritte 13, 14 existieren auch für die zweite Repetition II, in der dann allerdings Referenzdaten 16 des zweiten Teildatensatzes für die eine Schicht und Referenzdaten 15 des ersten Teildatensatzes für die andere Schicht herangezogen werden.

Die erhaltenen Parameter des Trennungsalgorithmus, hier also die entsprechenden Schicht-GRAPPA-Kerne, werden dann auf in den entsprechenden Repetitionen I, II aufgenommene überlagerte Magnetresonanzdaten 15 angewandt, um Magnetresonanzdaten 16 für die einzelnen Schichten und Teilbilddatensätze mittels des Trennungsalgorithmus abzuleiten.

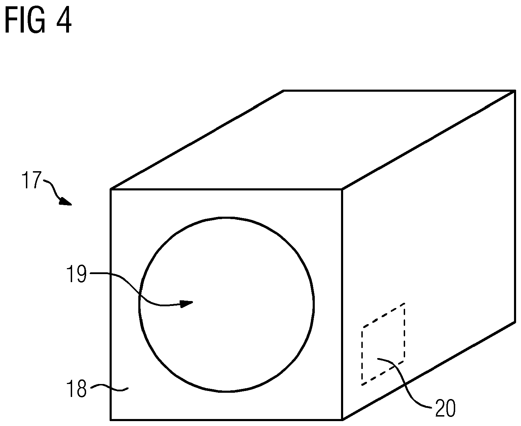

Fig. 4 zeigt schließlich eine Prinzipskizze einer erfindungsgemäßen Magnetresonanzeinrichtung 17, die eine Hauptmagneteinheit 18 aufweist, die eine Patientenaufnahme 19 definiert, in die ein Patient mittels einer hier nicht näher gezeigten Patientenliege eingefahren werden kann. Die Patientenaufnahme 19 umgebend können eine Hochfrequenzspulenanordnung und eine Gradientenspulenanordnung vorgesehen sein.

Der Betrieb der Magnetresonanzeinrichtung 17 wird durch eine Steuereinrichtung 20 gesteuert, welche zur Ausführung des erfindungsgemäßen Verfahrens ausgebildet ist. Hierzu kann die Steuereinrichtung 20 insbesondere eine Sequenzeinheit zur Steuerung der Aufnahme von Magnetresonanzdaten und Referenzdaten, eine Timing-Einheit zur Ermittlung von den Zeitablauf der Fig. 1 beschreibenden Aufnahmeparametern für die Sequenzeinheit, und wenigstens eine Rekonstruktionseinheit für die Schritte gemäß Fig. 3 und die entsprechende Rekonstruktion von Magnetresonanzbildern der Teildatensätze aufweisen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zur Aufnahme eines Magnetresonanzdatensatzes in einem mehrere Schichten umfassenden Aufnahmebereich eines Untersuchungsobjekts mit einer Magnetresonanzeinrichtung (17), wobei eine Bildgebungstechnik verwendet wird, die bei der Rekonstruktion von Magnetresonanzbildern Referenzdaten (11, 12, 15, 16) nutzt, wobei für alle Schichten wenigstens zwei Teildatensätze mit jeweils unterschiedlichen Kontrasten aufgenommen werden, indem ein erster Teildatensatz ohne einen und ein zweiter Teildatensatz mit einem Präparationspuls (1), insbesondere Inversionspuls, aufgenommen wird, wobei zur Aufnahme der Referenzdaten (11, 12, 15, 16) für wenigstens eine erste Schicht für den ersten Teildatensatz die Referenzdaten (12, 15) in einer Wartezeit (6) nach dem Präparationspuls (1) für wenigstens eine andere, zweite Schicht, von der Referenzdaten (11, 16) bezüglich des zweiten Teildatensatzes aufgenommen werden sollen, aufgenommen werden, wobei als Bildgebungstechnik eine Mehrschichtbildgebungstechnik verwendet wird, in der in einem Aufnahmeabschnitt gleichzeitig Magnetresonanzdaten (15) aus wenigstens zwei Schichten aufgenommen werden und in der die Magnetresonanzdaten (15) mittels eines die Referenzdaten (11, 12, 15, 16) der einzelnen Schichten nutzenden Trennungsalgorithmus den einzelnen Schichten zugeordnet werden.

2. Verfahren nach Anspruch 1, **dadurch gekennzeichnet, dass** zur Aufnahme der Referenzdaten (11, 12, 15, 16) eine Einzelschuss-TSE-Sequenz verwendet wird und/oder als erster Kontrast ein FLAIR-T2-Kontrast und als zweiter Kontrast ein reiner T2-Kontrast verwendet wird.

3. Verfahren nach Anspruch 1 oder 2, **dadurch gekennzeichnet, dass** zur Aufnahme der Referenzdaten (11, 12, 15, 16) Präparationspulse (1) für mehrere unterschiedliche zweite Schichten sukzessive ausgegeben werden, wobei zwischen der Ausgabe von zwei Präparationspulsen (1) und nach der Ausgabe des letzten Präparationspulses (1) jeweils Referenzdaten (12, 15) für von den zweiten Schichten unterschiedliche erste Schichten aufgenommen werden.

4. Verfahren nach einem der vorangehenden Ansprüche, **dadurch gekennzeichnet, dass** in jedem gemeinsamen Aufnahmeschritt für zwei Schichten jeweils für eine der Schichten mittels eines auf diese Schicht wirkenden Präparationspulses (1) Magnetresonanzdaten (16) des zweiten Teildatensatzes und für die andere Schicht Magnetresonanzdaten des ersten Teildatensatzes (16) aufgenommen werden.

5. Verfahren nach Anspruch 4, **dadurch gekennzeichnet, dass** zur Ermittlung der Parameter des Trennungsalgorithmus jeweils die den gemeinsam aufgenommenen Schichten entsprechenden Kombinationen der Referenzdaten (11, 12, 15, 16) herangezogen werden.

6. Magnetresonanzeinrichtung (17), aufweisend eine zur Durchführung eines Verfahrens nach einem der vorangehenden Ansprüche ausgebildete Steuereinrichtung (20).

7. Computerprogramm, welches bewirkt, dass die Schritte eines Verfahrens nach einem der Ansprüche 1 bis 5 durchgeführt werden, wenn es auf einer Steuereinrichtung (20) einer Magnetresonanzeinrichtung (17) ausgeführt wird.

8. Elektronisch lesbarer Datenträger, auf dem ein Computerprogramm nach Anspruch 7 gespeichert ist.

## Claims

1. Method for recording a magnetic resonance data record in a capture region of an examination object, said capture region comprising a plurality of slices, using a magnetic resonance apparatus (17), wherein an imaging technique is utilised which uses reference data (11, 12, 15, 16) in the reconstruction of magnetic resonance images, wherein for all the slices at least two partial data records are recorded with respectively different contrasts in that a first partial data record is recorded without and a second partial data record is recorded with a preparation pulse (1), in particular an inversion pulse,
wherein for recording the reference data (11, 12, 15, 16) for at least one first slice for the first partial data record, the reference data (12, 15) is recorded during a waiting time (6) after the preparation pulse (1) for at least one other, second slice from which reference data (11, 16) relating to the second partial data record is recorded, wherein, as an imaging technique, a multislice imaging technique is used in which in a recording portion, magnetic resonance data (15) is recorded simultaneously from at least two slices and in which the magnetic resonance data (15) is assigned to the individual slices by means of a separation algorithm using the reference data (11, 12, 15, 16) of the individual slices.

2. Method according to claim 1, **characterised in that** for recording the reference data (11, 12, 15, 16), a single-shot TSE sequence is used and/or as the first contrast, a FLAIR-T2 contrast and as the second contrast, a pure T2 contrast is used.

3. Method according to claim 1 or 2, **characterised in that** for recording the reference data (11, 12, 15, 16) preparation pulses (1) for a plurality of different second slices are output successively, wherein in each case between the output of two preparation pulses (1) and after the output of the last preparation pulse (1), reference data (12, 15) is recorded for first slices differing from the second slices.

4. Method according to one of the preceding claims, **characterised in that** in each joint recording step for two slices, in each case for one of the slices, magnetic resonance data (16) of the second partial data record and for the other slice magnetic resonance data of the first partial data record (16) is recorded by means of a preparation pulse (1) acting upon this slice.

5. Method according to claim 4, **characterised in that** for determining the parameters of the separation algorithm, in each case, the combinations of the reference data (11, 12, 15, 16) corresponding to the jointly recorded slices are called upon.

6. Magnetic resonance apparatus (17), having a control device (20) configured for carrying out a method according to one of the preceding claims.

7. Computer program which causes the steps of a method according to one of claims 1 to 5 to be carried out when it is executed in a control device (20) of a magnetic resonance apparatus (17).

8. Electronically-readable data carrier on which a computer program according to claim 7 is stored.

## Revendications

1. Procédé d'enregistrement d'un ensemble de données de résonnance magnétique dans une partie de réception, comprenant plusieurs tranches, d'un objet à examiner comprenant un dispositif (17) de résonnance magnétique, dans lequel on utilise une technique d'imagerie qui, lors de la reconstruction d'image de résonnance magnétique, utilise des données (11, 12, 15, 16) de référence, dans lequel on enregistre pour toutes les tranches au moins deux ensembles de données partiels ayant respectivement des contrastes différents, par le fait qu'on enregistre un premier ensemble de données partiel sans une impulsion (1) de préparation et un deuxième ensemble de données partiel avec une impulsion (1) de préparation, notamment une impulsion d'inversion,
dans lequel pour l'enregistrement des données (11, 12, 15, 16) de référence, pour au moins une première tranche, on enregistre pour le premier ensemble de données partiel les données (12, 15) de référence dans un temps (6) d'attente après l'impulsion(1) de préparation pour au moins une autre deuxième tranche, de laquelle des données (11, 16) de référence, en ce qui concerne le deuxième ensemble de données partiel, doivent être enregistrées, dans lequel on utilise comme technique d'imagerie une technique d'imagerie à plusieurs tranches, dans laquelle on enregistre dans une partie d'enregistrement en même temps des données (15) de résonnance magnétique d'au moins deux tranches et dans laquelle on associe les données (15) de résonnance magnétique aux diverses tranches au moyen d'un algorithme de séparation utilisant les données (11, 12, 15, 16) de référence des diverses tranches.

2. Procédé suivant la revendication 1, **caractérisé en ce que** pour l'enregistrement des données (11, 12, 15, 16) de référence, on utilise une séquence TSE à un seul coup et/ou on utilise comme premier contraste un contraste FLAIR-T2 et comme deuxième contraste un simple contraste T2.

3. Procédé suivant la revendication 1 ou 2, **caractérisé en ce que** pour l'enregistrement des données (11, 12, 15, 16) de référence, on émet successivement des impulsions (1) de préparation pour plusieurs deuxièmes tranches différentes, dans lequel entre l'émission de deux impulsions (1) de préparation et après l'émission de la dernière impulsion de préparation, on enregistre respectivement des données (12, 15) de référence pour des premières tranches différentes des deuxièmes tranches.

4. Procédé suivant l'une des revendications précédentes, **caractérisé en ce que** dans chaque stade d'enregistrement commun pour deux tranches, on enregistre respectivement pour l'une des tranches au moyen d'une impulsion (1) de préparation agissant sur cette tranche, des données (16) de résonnance magnétique du deuxième ensemble de données partiel, et pour l'autre tranche, des données de résonnance magnétique du premier ensemble (16) de données partiel.

5. Procédé suivant la revendication 4, **caractérisé en ce que** pour la détermination des paramètres de l'algorithme de séparation, on tire parti respectivement des combinaisons, correspondant aux tranches enregistrées conjointement, des données (11, 12, 15, 16) de référence.

6. Dispositif (17) de résonnance magnétique, comportant un dispositif (20) de commande constitué pour effectuer un procédé suivant l'une des revendications précédentes.

7. Programme d'ordinateur qui fait que les stades d'un procédé suivant l'une des revendications 1 à 5 sont effectués lorsqu'il est réalisé sur un dispositif (20) de commande d'un dispositif (17) de résonnance magnétique.

8. Support de données déchiffrables électroniquement, sur lequel est mis en mémoire un programme d'ordinateur suivant la revendication 7.
